# EUROPÄISCHE PATENTSCHRIFT

(11) **EP 1 430 497 B1**
(45) Veröffentlichungstag und Bekanntmachung des Hinweises auf die Patenterteilung: **23.11.2005**
(21) Anmeldenummer: 02798649.6
(22) Anmeldetag: 17.09.2002
(51) Int. Cl.: H01H 27/00, H03K 17/945

(54) **ZUHALTESYSTEM EINES SICHERHEITSSCHALTERS MIT EINEM LESEKOPF UND EINEM BETÄTIGER**
LOCKING SYSTEM OF A SAFETY SWITCH COMPRISING A READING HEAD AND AN ACTUATOR
SYSTEME DE VERROUILLAGE D'UN INTERRUPTEUR DE SECURITE COMPRENANT UNE TETE DE LECTURE ET UN ACTIONNEUR

(30) Priorität: 18.09.2001 DE 10146828
(43) Veröffentlichungstag der Anmeldung: 23.06.2004
(73) Patentinhaber: EUCHNER GmbH + Co. KG, 70771 Leinfelden-Echterdingen (DE)
(72) Erfinder: BÄCHLE, Erik, 70794 Filderstadt (DE)
(74) Vertreter: Crazzolara, Helmut
(86) Internationale Anmeldenummer: PCT/EP2002/010402
(87) Internationale Veröffentlichungsnummer: WO 2003/025963

(56) Entgegenhaltungen:
- DE-A- 3 324 242
- US-A- 5 254 879

## Beschreibung

Die vorliegende Erfindung betrifft ein Zuhaltesystem eines Sicherheitsschalters mit einem Betätiger nach dem Oberbegriff des Anspruchs 1.

Mit derartigen Sicherheitsschaltern können bewegliche Schutzeinrichtungen überwacht werden, wie beispielsweise Türen, Abdeckungen, Gitter und dgl., von Maschinen und Anlagen. In der Regel unterbricht der Sicherheitsschalter beim Öffnen der Schutzeinrichtung einen oder mehrere Stromkreise, wodurch die zugehörige Maschine in einen sicheren Betriebszustand überführt wird, beispielsweise abgeschaltet wird, oder deren Einschalten verhindert wird.

Weit verbreitet sind Sicherheitsschalter, bei denen ein in der Regel an der Schutzeinrichtung festgelegter Betätiger in einen Lesekopf des Gehäuses des Sicherheitsschalters einführbar ist. Das Einführen des Betätigers setzt üblicherweise einen jedenfalls partiellen Formschluß zwischen Betätiger und Lesekopf voraus und bewirkt unmittelbar oder mittels mechanischer Koppelelemente das Schalten des Sicherheitsschalters. Dieser Formschluß repräsentiert eine Art mechanische Codierung, so daß nur mit einem vorgebbaren Betätiger der Sicherheitsschalter betätigt werden kann. Durch Arretieren des Betätigers im Lesekopf ist die Schutzeinrichtung zuhaltbar. Das Arretieren kann beispielsweise elektromechanisch antreibbar und/oder elektromechanisch lösbar sein.

Die DE 43 28 297 C1 zeigt einen Sicherheitsschalter, bei dem der Schaltstößel gleichzeitig als Anker des den Verriegelungsmechanismus betätigenden Elektromagneten ausgebildet ist.

Die DE 697 06 775 T2 zeigt einen Sicherheitsschalter, bei dem der Betätiger in dem Sicherheitsschalter dadurch mechanisch verriegelt werden kann, daß ein quer zur Längsachse des Schaltstößels verschiebbarer und in dem Gehäuse des Sicherheitsschalters geführter und elektromagnetisch antreibbarer Verriegelungsschieber unterhalb des Lesekopfes in blockierenden Eingriff mit dem Schaltstößel bringbar ist. Der Verriegelungsschieber wirkt dabei über eine Kuppelvorrichtung mit umkehrbarer Betätigungsrampe mit dem elektromagnetischen Antrieb zusammen. Durch die Umkehrbarkeit der Betätigungsrampe kann vorgewählt werden, ob die Blockierung im spannungsfreien oder im spannungsbeaufschlagten Zustand des elektromagnetischen Antriebs erfolgt (NORMALLY LOCKED oder NORMALLY UNLOCKED).

Die DE 697 07 081 T2 zeigt einen Sicherheitsschalter, bei dem der Lesekopf in verschiedenen vorgegebenen Winkelpositionen an dem Gehäuse des Sicherheitsschalters festlegbar ist.

Weitere derartige oder ähnliche Sicherheitsschalter sind aus der DE 33 09 372 C2, DE 199 19 949 A1, DE 34 29 647 C2 und der DE 39 23 663 A1 bekannt.

Sicherheitsschalter einer abgewandelten Art, nämlich mit einem Lesekopf und einem Betätiger, die jeweils eine erste bzw. zweite Baugruppe mit elektrischen und/oder elektronischen Bauelementen aufweisen, die elektrisch kontaktlos in Wechselwirkung miteinander bringbar sind und dadurch den Sicherheitsschalter steuern, sind beispielsweise aus der DE 197 11 588 A1 bekannt.

Im zusammengeführten Zustand ist der Betätiger im Lesekopf mechanisch verriegelbar und dadurch die Schutzeinrichtung zuhaltbar. Das Zuhalten erfolgt nach dem Stand der Technik beispielsweise aufgrund des Durchgreifens einer Öffnung im Betätiger durch einen Stößel im Lesekopf. Damit die abhängig vom Anwendungsfall erforderlichen Zuhaltekräfte von beispielsweise 1000 N aufgebracht werden können, ist das Zuhaltesystem und mithin der Sicherheitsschalter entsprechend mechanisch robust auszuführen.

Der Betätiger wird in einen vom Lesekopf ausgebildeten Kanal eingeführt. In schmutzenden Umgebungen, wie beispielsweise in der Nähe von spanenden Bearbeitungsmaschinen, kann die auftretende Verschmutzung des Sicherheitsschalters und des Zuhaltesystems die Bereitsstellung hoher Zuhaltekräfte und auch die sonstige Funktion beeinträchtigen.

Aus der DE 199 53 898 A1 ist eine Zugangsschutzeinrichtung bekannt, bei der die Zuhaltung aus einem Magnetkreis besteht, der ein an dem beweglichen Teil befindliches, magnetisierbares Joch sowie einen mit dem Joch schließbaren, U-förmigen Magneten umfaßt, dessen magnetische Wirkung ein- und ausschaltbar ist.

Der vorliegenden Erfindung liegt das Problem zugrunde, ein Zuhaltesystem eines Sicherheitsschalters weiter zu verbessern, insbesondere hohe Zuhaltekräfte mit geringem konstruktiven Aufwand zu realisieren. Außerdem soll die Funktion des Zuhaltesystems und des Sicherheitsschalters auch in schmutzender Umgebung gewährleistet sein und der räumliche Ansprechbereich des Wechselwirkungssystems in Abhängigkeit des Anwendungsfalls voll ausnutzbar sein.

Das Problem ist durch das im Anspruch 1 bestimmte Zuhaltesystem gelöst. Besondere Ausführungsarten sind in den Unteransprüchen bestimmt.

Das Problem ist erfindungsgemäß dadurch gelöst, dass der Betätiger am Lesekopf mittels eines mit einem Gegenelement zusammenwirkenden schaltbaren Elektromagnet zuhaltbar ist, dass das Gegenelement und/oder der Elektromagnet mit einem zugehörigen Grundelement fest verbunden, aber diesem gegenüber schwenkbar ist, und dass die erste und/oder zweite Baugruppe in dem jeweiligen Gegenelement integriert ist.

Die Zuhaltung erfolgt daher nicht oder jedenfalls nicht ausschließlich durch einen quer zur Bewegungsrichtung des Betätigers verschiebbaren Riegel, sondern durch elektromagnetische Krafteinwirkung auf das Gegenelement. Der Elektromagnet ist durch den Sicherheitsschalter selbst und/oder eine zugehörige Steuereinrichtung und/oder durch die zum Sicherheitsschalter zugehörige Maschine schaltbar. Die Höhe der Zuhaltekraft kann einstellbar sein, beispielsweise in Abhängigkeit des Betriebszustandes der zugehörigen Maschine. Dadurch, dass das Gegenelement und/oder der Elektromagnet gegenüber dem Grundelement schwenkbar gelagert ist, sind beim Zuhalten der Elektromagnet und der Betätiger so nah benachbart, dass ausreichend hohe Zuhaltekräfte realisierbar sind. Dadurch, dass die erste und/oder zweite Baugruppe in dem jeweiligen Gegenelement integriert ist, ist eine Wechselwirkung der Baugruppen auch unter ungünstigen Umständen zuverlässig gewährleistet, beispielsweise auch bei einem Winkelversatz der Schutzeinrichtung.

Die elektrisch kontaktlose Wechselwirkung zwischen Lesekopf und Betätiger kann mit allen aus dem Stand der Technik bekannten Verfahren realisiert werden, im einfachsten Fall durch eine Dämpfung elektromagnetischer Wellen, insbesondere eines elektromagnetischen Feldes. Alternativ dazu kann auch ein sogenanntes Transponder-System eingesetzt werden, bei dem zwischen Lesekopf und Betätiger elektrisch kontaktlos Identifikationssignale ausgetauscht werden. Nach dem Stand der Technik wird der räumliche Ansprechbereich des Wechselwirkungssystems nur begrenzt ausgenützt und es ist ein verhältnismäßig exaktes Ausrichten von Lesekopf und Betätiger im zusammengeführten Zustand zueinander erforderlich.

Vorzugsweise weist der Lesekopf ein Kopfgehäuse auf, an dem der Elektromagnet und die erste Baugruppe unbeweglich festgelegt sind. Dadurch ist die elektrische Kontaktierung insbesondere des Elektromagneten vereinfacht.

Vorzugsweise weist der Betätiger das Grundelement, das Gegenelement und die zweite Baugruppe auf, insbesondere ist der Betätiger durch diese Elemente gebildet. Diese bewegliche Ausführung des Gegenelements am Betätiger ist insbesondere dann vorteilhaft, wenn die zweite Baugruppe, wie im bevorzugten Ausführungsbeispiel der Erfindung, keine elektrischen Anschlußleitungen aufweist.

Vorzugsweise ist das Gegenelement gegenüber dem Grundelement um zwei Achsen schwenkbar, die einen rechten Winkel miteinander einschließen. Dadurch läßt sich in vorgebarem Maß ein beliebiger Winkelversatz des Betätigers gegenüber dem Lesekopf und damit des beweglichen Teils der Schutzeinrichtung ausgleichen. Soweit erforderlich oder vorteilhaft, kann das Gegenelement auch um eine dritte Achse jedenfalls in einem begrenzten Maß schwenkbar sein, die insbesondere durch die Abstandsrichtung zwischen Gegenelement und Grundelement gegeben ist. Die Schwenkbereiche können durch die geometrische Ausgestaltung von Gegenelement und/oder Grundelement unter Bildung mechanischer Anschläge begrenzt sein, erforderlichenfalls unterschiedlich hinsichtlich der drei Achsen.

Dadurch, dass das Gegenelement gegenüber dem Grundelement in deren Abstandsrichtung im wesentlichen nicht verschiebbar ist, ist die Zuhaltung weiter verbessert, weil die Möglichkeit verhindert ist, beim Versuch die Schutzeinrichtung im zugehaltenen Zustand zu öffnen, zunächst die Schutzeinrichtung zuzudrücken und damit "Anlauf" für die Öffnungsbewegung zu holen.

In einer besonderen Ausführungsart der Erfindung ist der Schwenkbereich des Gegenelements gegenüber dem Grundelement insbesondere um die durch deren Abstandsrichtung bestimmte Achse durch eine vorzugsweise mechanische Anschlageinrichtung begrenzt. Dadurch ist eine Vor-Ausrichtung des Gegenelements und insbesondere der zugehörigen Baugruppe gewährleistet, und damit eine sichere Wechselwirkung zwischen Lesekopf und Betätiger gewährleistet.

Vorzugsweise ist zwischen dem Gegenelement und dem Grundelement ein federelastisch verformbares Element angeordnet, durch das auf das Gegenelement eine dieses in eine Grundposition gegenüber dem Grundelement rückstellende Kraft ausübbar ist. Dadurch ist die Vor-Ausrichtung des Gegenelements weiter verbessert. Auf besonders zuverlässige und einfache Weise kann das federelastisch verformbare Element durch eine Tülle aus Gummi oder Kunststoff gebildet sein, durch die ein Verbindungselement hindurchtritt, welches das Grundelement mit dem Gegenelement fest verbindet.

In einer besonderen Ausführungsart der Erfindung bildet der Elektromagnet eine erste Anlagefläche aus und das Gegenelement bildet eine zweite Anlagefläche aus, wobei bei der Zuhaltung die erste Anlagefläche in flächige Anlage an die zweite Anlagefläche bringbar ist. Dadurch sind zuverlässig und dauerhaft hohe Zuhaltekräfte realisierbar.

In entsprechender Wiese bilden die erste und zweite Baugruppe einander zugeordnete dritte und vierte Anlageflächen aus, die bei der Zuhaltung in vorzugsweise flächiger Anlage zueinander bringbar sind. Dadurch ist eine zuverlässige Wechselwirkung zwischen Betätiger und Lesekopf gewährleistet.

Weitere Vorteile, Merkmale und Einzelheiten der Erfindung ergeben sich aus den Unteransprüchen sowie der nachfolgenden Beschreibung, in der unter Bezugnahme auf die Zeichnungen ein Ausführungsbeispiel im Einzelnen beschrieben ist. Dabei können die in den Ansprüchen und in der Beschreibung erwähnten Merkmale jeweils einzeln für sich oder in beliebiger Kombination erfindungswesentlich sein.
- Fig. 1: zeigt eine perspektivische Ansicht des Lesekopfes eines Sicherheitsschalters mit einem erfindungsgemäßen Zuhaltesystem,
- Fig. 2: zeigt eine perspektivische Ansicht eines zugehörigen Betätigers,
- Fig. 3: zeigt eine perspektivische Ansicht eines Schnittes durch den Betätiger,
- Fig. 4: zeigt einen Schnitt durch den Lesekopf und den Betätiger des Zuhaltesystems im zusammengeführten Zustand, und
- Fig. 5: zeigt einen Schnitt ähnlich der Fig. 4, aber im ausgelenkten Zustand des Betätigers.

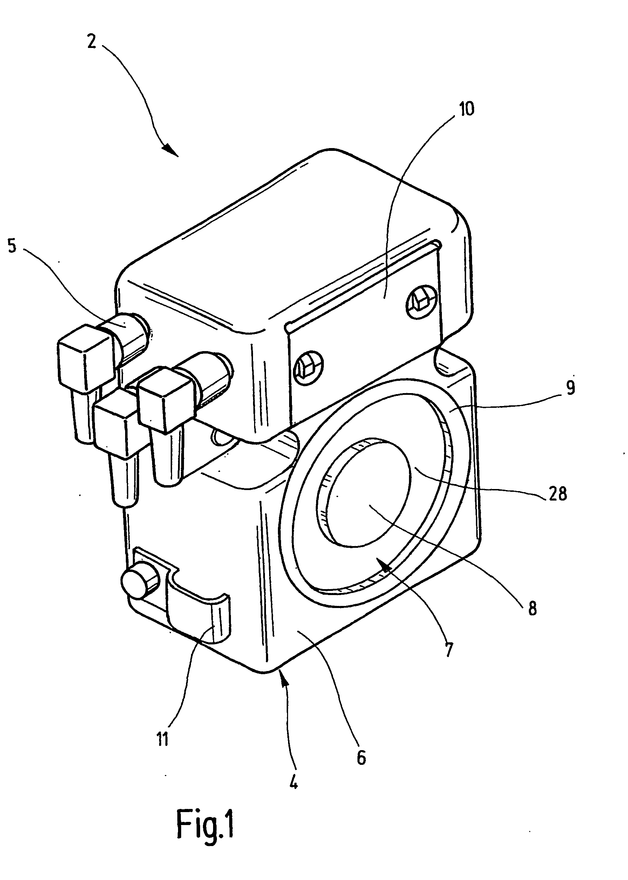

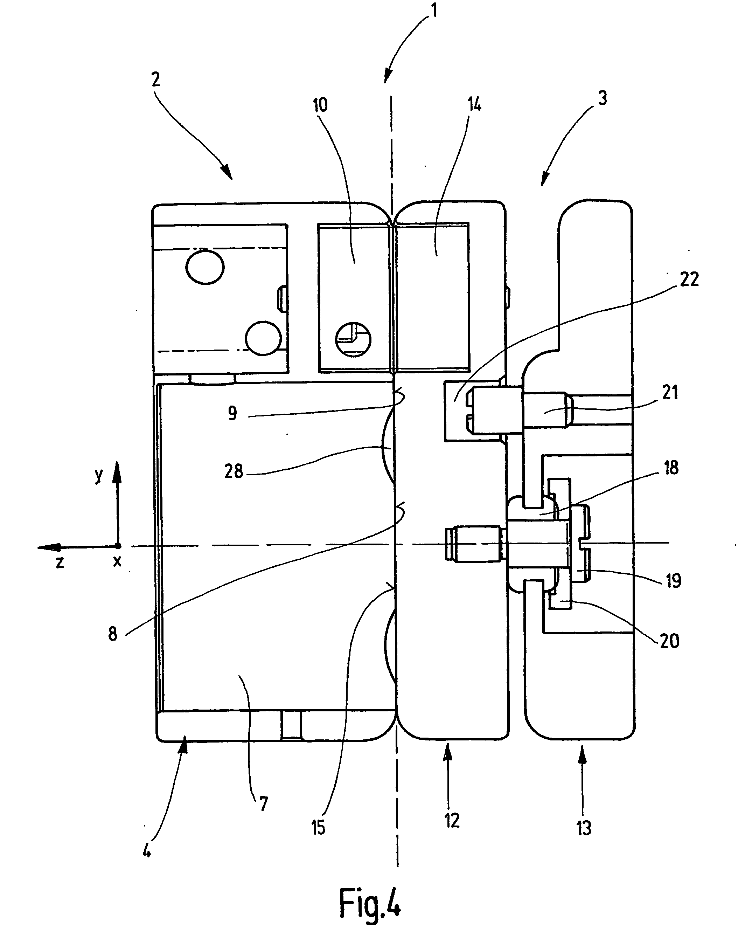

Die Fig.1 zeigt eine perspektivische Ansicht des Lesekopfes 2 eines Sicherheitsschalters mit einem erfindungsgemäßen Zuhaltesystem 1 (Fig. 4). Der Lesekopf 2 ist mindestens Teil des nicht weiter dargestellten Sicherheitsschalters. Die elektrische Schaltfunktion kann innerhalb des Kopfgehäuses 4 ausgeführt werden oder in einem von dem Kopfgehäuse 4 entfernt angeordneten Schalterteil des Sicherheitsschalters. Die elektrische Kontaktierung des Lesekopfes 2 erfolgt über einen oder mehrere Steckverbinder 5. Das Kopfgehäuse 4 ist im wesentlichen quaderförmig mit einer im wesentlichen rechteckförmigen Frontfläche 6. In einem unteren Bereich weist das Kopfgehäuse 4 eine kreiszylindrische Bohrung auf, deren Längsachse mit der Frontfläche 6 einen rechten Winkel einschließt und in die der Elektromagnet 7 einsetzbar ist. In einem bevorzugten Ausführungsbeispiel ist der Lesekopf 2 mittels des Kopfgehäuses 4 an einem Rahmen der (nicht dargestellten) Schutzeinrichtung oder der Maschine selbst festgelegt.

Der Elektromagnet 7 weist ein im wesentlichen kreiszylindrisches Gehäuse auf, das auf seiner dem Betätiger 3 zugewandten Seite eine im wesentlichen kreisförmige erste Anlagefläche 8 ausbildet. Radial außenseitig bildet das Gehäuse des Elektromagneten 7 einen ringförmigen Rand 9 aus, der von der ersten Anlagefläche 8 durch eine ringförmige Nut 28 beabstandet ist. Die erste Anlagefläche 8, der ringförmige Rand 9 und die Frontfläche 6 liegen vorzugsweise in einer planen Ebene.

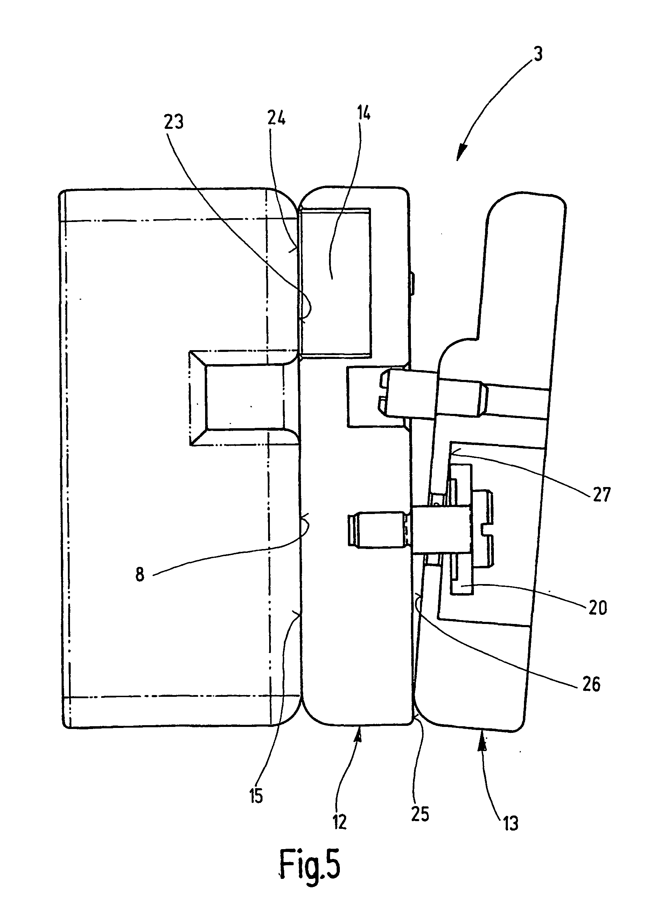

Oberhalb des Elektromagneten 7 ist in dem Kopfgehäuse 4 die erste Baugruppe 10 unbeweglich festgelegt, insbesondere lösbar mit dem Kopfgehäuse 4 verschraubt. Die Verdrahtung zwischen der ersten Baugruppe 10, dem Elektromagneten 7 und dem Anschluß für den Steckverbinder 5 erfolgt vorzugsweise innerhalb des Kopfgehäuses 4. An einer Seitenfläche ist an dem Kopfgehäuse 4 eine Kabelschelle 11 zur Fixierung der Anschlußleitungen für die Steckverbinder 5 angeordnet.
Die vorzugsweise plane Frontfläche oder dritte Anlagefläche 23 (Fig. 5) der ersten Baugruppe 10 fluchtet mit der ersten Anlagefläche 8 oder ist dieser gegenüber geringfügig zurückversetzt.

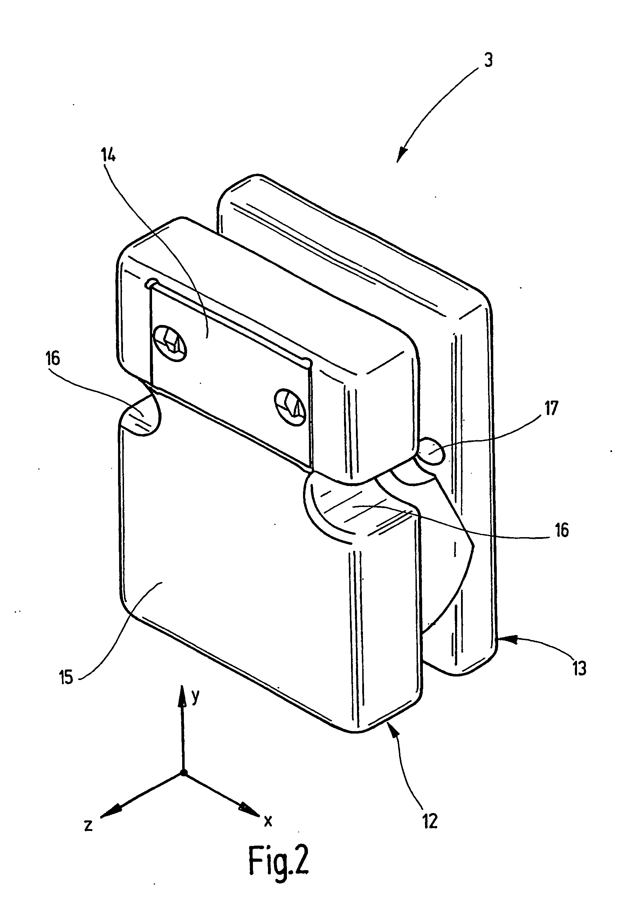

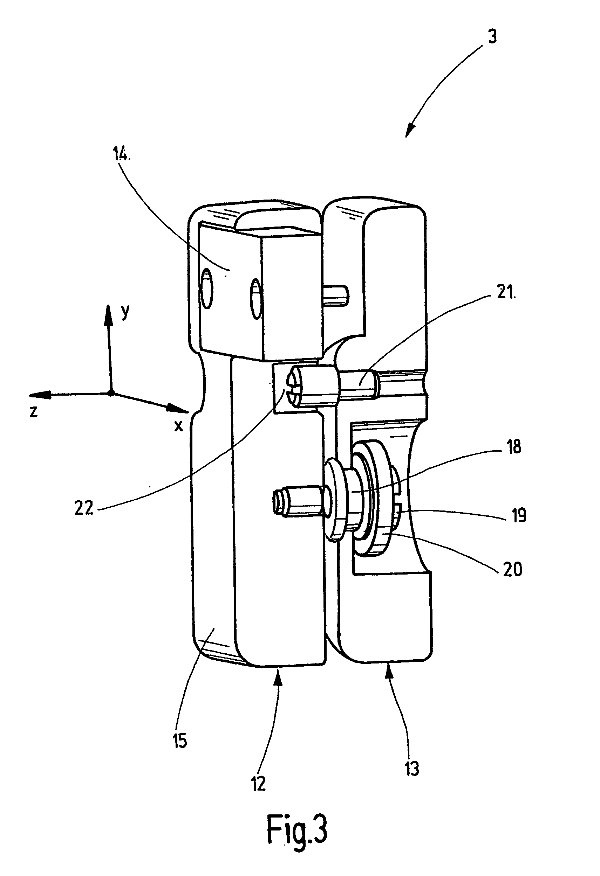

Die Fig. 2 zeigt eine perspektivische Ansicht eines zugehörigen Betätigers 3. Der Betätiger 3 weist ein Gegenelement 12 auf, beispielsweise aus Stahl, mit dem der Betätiger 3 am Lesekopf 2 durch den Elektromagneten 7 fixierbar und damit die Schutzeinrichtung zuhaltbar ist. Das Gegenelement 12 kann einstückig aus Stahl sein oder nur teilweise, beispielsweise unter Bildung eines Rahmens aus Aluminium zur Aufnahme eines mit dem Elektromagneten zusammenwirkenden Einsatzstückes. Das Gegenelement 12 ist mit einem zugehörigen Grundelement 13, beispielsweise aus Aluminium, fest verbunden, aber diesem gegenüber schwenkbar, wie bei der nachfolgenden Beschreibung zu den Fig. 3 bis 5 erläutert wird. Die mit der ersten Baugruppe 10 des Lesekopfes 2 elektrisch kontaktlos in Wechselwirkung bringbare zweite Baugruppe 14 ist fest mit dem Gegenelement 12 verbunden, vorzugsweise lösbar mittels Befestigungsschrauben an diesem festgelegt.

Das Gegenelement 12 bildet eine plane zweite Anlagefläche 15 aus, die bei der Zuhaltung an die erste Anlagefläche 8 des Lesekopfes 2 in flächige Anlage bringbar ist. Die vorzugsweise plane Frontfläche oder vierte Anlagefläche 24 (Fig. 5) der zweiten Baugruppe 14 fluchtet mit der zweiten Anlagefläche 15 oder ist dieser gegenüber geringfügig zurückversetzt. Wesentlich ist dabei, dass durch die Anordnung der ersten und zweiten Baugruppe 10, 14 das Kontaktieren der ersten und zweiten Anlagefläche 8, 15 des Elektromagneten 7 bzw. des Gegenelements 12 gewährleistet ist, weil dadurch besonders hohe Zuhaltekräfte erzielbar sind.

Der Betätiger 3 ist beispielsweise mittels des Grundelements 13 an einer Schutzeinrichtung für eine von dem Sicherheitsschalter schaltbaren Maschine festgelegt. Gegenüber dieser Schutzeinrichtung ist das Gegenelement 12 zusammen mit der zweiten Baugruppe 14 um die drei in der Fig. 2 dargestellten und miteinander jeweils einen rechten Winkel einschließenden Raumrichtungen x, y, z schwenkbar. Die Abstandsrichtung zwischen Gegenelement 12 und Grundelement 13 ist dabei durch die Raumrichtung z repräsentiert. In dieser Abstandsrichtung z ist das Gegenelement 12 gegenüber dem Grundelement 13 im wesentlichen nicht verschiebbar. Sowohl das Gegenelement 12 als auch das Grundelement 13 weisen eine im wesentlichen quaderförmige Grundgestalt auf mit abgerundeten Kanten und Ecken. Die nutenförmigen Ausnehmungen 16 im Gegenelement 12 dienen der Zugänglichkeit für Befestigungsmittel, insbesondere Schrauben, die in die Befestigungslöcher 17 im Grundelement 13 einführbar sind und mittels denen der Betätiger 3 an dem beweglichen Teil der Schutzeinrichtung festlegbar ist.

In dem dargestellten Ausführungsbeispiel weist die zweite Baugruppe 14 keine Anschlußleitungen auf, so dass eine elektrische Kontaktierung des Betätigers 3 nicht erforderlich ist. Vorzugsweise wird über die im Lesekopf 2 angeordnete erste Baugruppe 10 Energie in die zweite Baugruppe 14 im Betätiger 3 übertragen, um in der zweiten Baugruppe 14 gespeicherte ldentifikationsdaten auszulesen und zur ersten Baugruppe 10 zurück zu übertragen. In einer vereinfachten Ausführung kann die zweite Baugruppe 14 auch lediglich ein von der ersten Baugruppe 10 erzeugtes elektromagnetisches Feld in vorgebbarer Weise dämpfen und dadurch der ersten Baugruppe 10 bzw. dem Lesekopf 2 die Anwesenheit der zweiten Baugruppe 14 und damit die geschlossene Stellung der Schutzeinrichtung anzeigen.

Die Fig. 3 zeigt eine perspektivische Ansicht eines Schnittes durch den Betätiger 3. Erkennbar ist dabei insbesondere die Anlenkung des Gegenelements 12 am Grundelement 13. Auf der dem Gegenelement 12 abgewandten Seite weist das Grundelement 13 hierfür eine Bohrung auf, in deren Bodenfläche 27 (Fig. 5) eine Durchgangsöffnung zu der dem Gegenelement 12 zugewandten Seite des Grundelements 13 vorgesehen ist.

In dieser Durchgangsöffnung ist ein federelastisch verformbares Element 18 angeordnet, insbesondere eingeknüpft, durch das auf das Gegenelement 12 eine dieses in eine Grundposition gegenüber dem Grundelement 13 rückstellende Kraft ausübbar ist. Im dargestellten Ausführungsbeispiel ist das federelastisch verformbare Element 18 durch eine Tülle aus Gummi oder Kunststoff gebildet, durch die ein das Grundelement 13 mit dem Gegenelement 12 verbindendes Verbindungselement 19 hindurchtritt. Zum Schutz des federelastisch verformbaren Elements 18 gegen mechanische Überbeanspruchung ist zwischen diesem und dem Verbindungselement 19 eine Unterlegscheibe 20 angeordnet. Im dargestellten Ausführungsbeispiel ist das Verbindungselement 19 eine lösbare und vorzugsweise selbstsichernde Verbindungsschraube, die in eine entsprechende Gewindebohrung im Gegenelement 12 einschraubbar ist.

Um die Achse z in Abstandsrichtung ist das Gegenelement 12 gegenüber dem Grundelement 13 nur innerhalb eines von einer mechanischen Anschlageinrichtung vorgebbaren Bereichs schwenkbar. Die mechanische Anschlageinrichtung ist im dargestellten Ausführungsbeispiel durch eine Anschlagschraube 21 realisiert, die auch als Gewindestift, Drehteil, harter Zylinderstift, Spannhülse oder dergleichen, ausgeführt sein kann. Diese Anschlagschraube 21 ragt in eine zugeordnete Anschlagöffnung 22 hinein, die auf der dem Grundelement 13 zugewandten Fläche des Gegenelements 12 angeordnet ist und deren geometrische Abmessungen letztlich den Schwenkbereich um die Achse z bestimmen.

Nach einer besonderen (nicht dargestellten) Ausführungsart der Erfindung weist die Anschlageinrichtung eine Dämpfungseinrichtung auf, um im Betrieb des Zuhaltesystems 1 eine Geräuschentwicklung aufgrund des Aneinanderstoßens der Komponenten der Anschlageinrichtung zu vermeiden, beispielsweise durch Zwischenlage von federelastisch verformbaren Elementen. Insbesondere kann beispielsweise die Anschlagschraube 21 bzw. ein entsprechender Gewindestift einen dämpfenden O-Ring tragen und/oder in der Anschlagöffnung 22 ein entsprechender Dämpfungsring angeordnet sein.

Die Fig. 4 zeigt einen Schnitt in der y/z-Ebene durch den Lesekopf 2 und den Betätiger 3 des Zuhaltesystems 1 im zusammengeführten Zustand.
In dem dargestellten Querschnitt ist insbesondere die Form des federelastisch verformbaren Elements 18 erkennbar, das rotationssymmetrisch in Bezug auf die Abstandsrichtung z ausgebildet ist. Die Unterlegscheibe 20 ist im wesentlichen topfförmig ausgebildet und bildet einen Anschlag insbesondere beim Zuhalten und der damit verbundenen Kraftübertragung von dem Gegenelement 12 über das Verbindungselement 19 auf das Grundelement 13, und damit vom Lesekopf 2 auf den Betätiger 3 bzw. die Schutzeinrichtung, und/oder beim Eindrehen des Verbindungselements 19 und/oder beim Verschwenken des Gegenelements 12 gegenüber dem Grundelement 13. Die Tülle 18 ist dabei sowohl in Anlage an dem Grundelement 13 als auch an dem Verbindungselement 12, und dämpft bei auftretenden Vibrationen oder Stößen die Schwingungsneigung des Gegenelements 12 und verhindert dadurch eine Geräuschentwicklung bzw. ein Klappern, beispielsweise verursacht durch ein Anschlagen des Gegenelements 12 am Grundelement 13.

Die Fig. 5 zeigt einen Schnitt ähnlich der Fig. 4, aber im ausgelenkten Zustand des Betätigers 3. Aus Gründen der Übersichtlichkeit ist das federelastisch verformbare Element 18 in dieser Darstellung nicht gezeigt. Erkennbar ist aber, dass beim gezeigten Verschwenken des Gegenelements 12 gegenüber dem Grundelement 13 die plane Anlage der zweiten Anlagefläche 15 des Gegenelements 12 an der ersten Anlagefläche 8 des Elektromagneten 7 und damit hohe Zuhaltekräfte gewährleistet sind. In entsprechender Weise ist die dritte Anlagefläche 23 der ersten Baugruppe 10 in planer Anlage an der vierten Anlagefläche 24 der zweiten Baugruppe 14 und dadurch ist eine sichere elektromagnetische Wechselwirkung zwischen der ersten und zweiten Baugruppe 10, 14 gewährleistet.

Der Schwenkbereich des Gegenelements 12 gegenüber dem Grundelement 13, im dargestellten Fall um die Raumrichtung x senkrecht zur Zeichenebene in der Fig. 5, ist dadurch begrenzt dass die gegenüber der Schwenkachse auskragende und dem Grundelement 13 zugewandte Fläche 25 des Gegenelements 12 in Anlage an die dem Gegenelement 12 zugewandte Stirnfläche 26 des Grundelements 13 kommt. Alternativ oder ergänzend ist in dieser Anschlagposition die Unterlegscheibe 20 mit ihrem topfförmigen Rand an mindestens einer Stelle in Anlage an der Bodenfläche 27 des Grundelements 13.

## Patentansprüche

1. Zuhaltesystem (1) eines Sicherheitsschalters mit einem Lesekopf (2) und einem Betätiger (3), die jeweils eine von einer ersten bzw. zweiten Baugruppe (10, 14) mit elektrischen und/oder elektronischen Bauelementen aufweisen, die elektrisch kontaktlos in Wechselwirkung miteinander bringbar sind und **dadurch** den Sicherheitsschalter steuern, **dadurch gekennzeichnet, dass** der Betätiger (3) am Lesekopf (2) mittels eines mit einem Gegenelement (12) zusammenwirkenden schaltbaren Elektromagneten (7) zuhaltbar ist, dass das Gegenelement (12) und/oder der Elektromagnet (7) mit einem zugehörigen und am Betätiger (3) bzw. am Lesekopf (2) festgelegten Grundelement (13) fest verbunden, aber diesem gegenüber schwenkbar ist, und dass die erste oder zweite Baugruppe (10, 14) in dem jeweiligen Gegenelement (12) integriert ist.

2. Zuhaltesystem nach Anspruch 1, **dadurch gekennzeichnet, dass** der Lesekopf (2) ein Kopfgehäuse (4) aufweist, an dem der Elektromagnet (7) und die erste Baugruppe (10) unbeweglich festgelegt sind.

3. Zuhaltesystem nach Anspruch 1 oder 2, **dadurch gekennzeichnet, dass** der Betätiger (3) das Grundelement (13), das Gegenelement (12) und die zweite Baugruppe (14) aufweist.

4. Zuhaltesystem nach einem der Ansprüche 1 bis 3, **dadurch gekennzeichnet, dass** das Gegenelement (12) gegenüber dem Grundelement (13) um zwei Achsen (x, y) schwenkbar ist, die einen rechten Winkel miteinander einschließen.

5. Zuhaltesystem nach einem der Ansprüche 1 bis 4, **dadurch gekennzeichnet, dass** das Gegenelement (12) gegenüber dem Grundelement (13) in deren Abstandsrichtung im wesentlichen nicht verschiebbar ist.

6. Zuhaltesystem nach einem der Ansprüche 1 bis 5, **dadurch gekennzeichnet, dass** der Schwenkbereich des Gegenelements (12) gegenüber dem Grundelement (13) um eine durch deren Abstandsrichtung bestimmte Achse (z) durch eine Anschlageinrichtung begrenzt ist.

7. Zuhaltesystem nach einem der Ansprüche 1 bis 6, **dadurch gekennzeichnet, dass** zwischen dem Gegenelement (12) und dem Grundelement (13) ein federelastisch verformbares Element (18) angeordnet ist, durch das auf das Gegenelement (12) eine dieses in eine Grundposition gegenüber dem Grundelement (13) rückstellende Kraft ausübbar ist.

8. Zuhaltesystem nach Anspruch 7, **dadurch gekennzeichnet, dass** das federelastisch verformbare Element (18) eine Tülle aus Gummi oder Kunststoff ist, durch die ein Verbindungselement (19) hindurchtritt, welches das Grundelement (13) mit dem Gegenelement (12) fest verbindet.

9. Zuhaltesystem nach einem der Ansprüche 1 bis 8, **dadurch gekennzeichnet, dass** der Elektromagnet (7) eine erste Anlagefläche (8) ausbildet und das Gegenelement (12) eine zweite Anlagefläche (15) ausbildet, und dass bei der Zuhaltung die erste Anlagefläche (8) in flächige Anlage an die zweite Anlagefläche (15) bringbar ist.

10. Zuhaltesystem nach einem der Ansprüche 1 bis 9, **dadurch gekennzeichnet, dass** die erste und zweite Baugruppe (10, 14) einander zugeordnete dritte und vierte Anlageflächen (23, 24) ausbilden, die bei der Zuhaltung in vorzugsweise flächige Anlage zueinander bringbar sind.

## Claims

1. Locking system (1) for a safety switch having a reading head (2) and an actuator (3) which each have one of a first or second module (10, 14) having electrical and/or electronic structural components which can be caused to mutually interact electrically in a contactless manner and thereby control the safety switch, **characterised in that** the actuator (3) can be locked on the reading head (2) by means of a switchable electromagnet (7) which co-operates with a counter element (12), **in that** the counter element (12) and/or the electromagnet (7) is/are fixedly connected to an associated base element (13) which is fixed to the actuator (3) or to the reading head (2) but can be pivoted relative thereto, and **in that** the first or second module (10, 14) is integrated in the respective counter element (12).

2. Locking system according to claim 1, **characterised in that** the reading head (2) has a head housing (4), on which the electromagnet (7) and the first module (10) are fixed in a non-movable manner.

3. Locking system according to claim 1 or 2, **characterised in that** the actuator (3) has the base element (13), the counter element (12) and the second module (14).

4. Locking system according to any one of claims 1 to 3, **characterised in that** the counter element (12) can be pivoted relative to the base element (13) about two axes (x, y) which enclose a right angle with each other.

5. Locking system according to any one of claims 1 to 4, **characterised in that** the counter element (12) is substantially non-displaceable relative to the base element (13) in the spacing direction thereof.

6. Locking system according to any one of claims 1 to 5, **characterised in that** the pivot region of the counter element (12) is limited relative to the base element (13) by means of a stop device about an axis (z) which is determined by the spacing direction thereof.

7. Locking system according to any one of claims 1 to 6, **characterised in that** there is arranged, between the counter element (12) and the base element (13), a resiliently deformable element (18) by means of which a force can be applied to the counter element (12) and returns the counter element (12) to an initial position relative to the base element (13).

8. Locking system according to claim 7, **characterised in that** the resiliently deformable element (18) is a grommet of rubber or plastics material through which a connection element (19) extends which fixedly connects the base element (13) to the counter element (12).

9. Locking system according to any one of claims 1 to 8, **characterised in that** the electromagnet (7) forms a first contact face (8) and the counter element (12) forms a second contact face (15), and **in that** the first contact face (8) can be brought into surface contact with the second contact face (15) during the locking operation.

10. Locking system according to any one of claims 1 to 9, **characterised in that** the first and second module (10, 14) form third and fourth contact faces (23, 24) which are associated with each other and which can be brought into preferably surface contact with each other during the locking operation.

## Revendications

1. Système d'interverrouillage (1) d'un coupe-circuit doté d'une tête de lecture (2) et d'un organe de commande (3) qui présentent respectivement un premier ou un deuxième bloc (10, 14) avec des éléments électriques et/ou électroniques qui peuvent être amenés à interagir les uns avec les autres sans contact électrique et qui commandent ainsi le coupe-circuit, **caractérisé en ce que** l'organe de commande (3) peut être verrouillé sur la tête de lecture (2) à l'aide d'un électroaimant (7) pouvant être commuté conjointement avec un contre-élément (12), **en ce que** le contre-élément (12) et/ou l'électroaimant (7) est relié fixement à un élément de base (13) correspondant fixé à l'organe de commande (3) ou à la tête de lecture (2), mais peut pivoter par rapport à cet élément de base et **en ce que** le premier ou le deuxième bloc (10, 14) est intégré dans le contre-élément (12) respectif.

2. Système d'interverrouillage selon la revendication 1, **caractérisé en ce que** la tête de lecture (2) présente un boîtier de tête (4) sur lequel sont fixés de manière inamovible l'électroaimant (7) et le premier bloc (10).

3. Système d'interverrouillage selon la revendication 1 ou 2, **caractérisé en ce que** l'organe de commande (3) présente l'élément de base (13), le contre-élément (12) et le deuxième bloc (14).

4. Système d'interverrouillage selon l'une quelconque des revendications 1 à 3, **caractérisé en ce que** par rapport à l'élément de base (13), le contre-élément (12) peut pivoter autour de deux axes (x, y) formant un angle droit l'un par rapport à l'autre.

5. Système d'interverrouillage selon l'une quelconque des revendications 1 à 4, **caractérisé en ce que** le contre-élément (12) ne peut essentiellement pas être déplacé par rapport à l'élément de base (13) dans sa direction d'espacement.

6. Système d'interverrouillage selon l'une quelconque des revendications 1 à 5, **caractérisé en ce que** la zone de pivotement du contre-élément (12) est limitée par un dispositif de butée par rapport à l'élément de base (13) autour d'un certain axe (z) déterminé par sa direction d'espacement.

7. Système d'interverrouillage selon l'une quelconque des revendications 1 à 6, **caractérisé en ce qu'**un élément (18) déformable élastiquement permettant d'exercer sur le contre-élément (12) une force le ramenant dans une position de base par rapport à l'élément de base (13) est disposé entre l'élément de base (12) et le contre-élément (13).

8. Système d'interverrouillage selon la revendication 7, **caractérisé en ce que** l'élément (18) déformable élastiquement est une tulle en caoutchouc ou en matière synthétique que traverse un élément de fixation (19) reliant fixement l'élément de base (13) au contre-élément (12).

9. Système d'interverrouillage selon l'une quelconque des revendications 1 à 8, **caractérisé en ce que** l'électroaimant (7) forme une première surface d'appui (8) et le contre-élément (12) une deuxième surface d'appui (15) et **en ce que** la première surface d'appui (8) peut être amenée dans l'installation plane sur la deuxième surface d'appui (15) en cas d'interverrouillage.

10. Système d'interverrouillage selon l'une quelconque des revendications 1 à 9, **caractérisé en ce que** le premier et le deuxième blocs (10, 14) forment des troisième et quatrième surfaces d'appui (23, 24) associées l'une à l'autre et pouvant être amenées l'une vers l'autre dans une installation de préférence plane en cas d'interverrouillage.
